# EUROPÄISCHE PATENTSCHRIFT

(11) **EP 1 317 674 B1**
(45) Veröffentlichungstag und Bekanntmachung des Hinweises auf die Patenterteilung: **14.06.2006**
(21) Anmeldenummer: 01965157.9
(22) Anmeldetag: 01.08.2001
(51) Int. Cl.: G01R 31/309

(54) **VERFAHREN UND VORRICHTUNG ZUR PRÜFUNG VON LEITERPLATTEN AUF IHRE FUNKTIONSFÄHIGKEIT**
METHOD AND DEVICE FOR TESTING THE OPERATIVENESS OF PRINTED CIRCUIT BOARDS
PROCEDE ET DISPOSITIF PERMETTANT DE TESTER LE FONCTIONNEMENT DE CARTES DE CIRCUITS IMPRIMES

(30) Priorität: 05.08.2000 DE 10038313
(43) Veröffentlichungstag der Anmeldung: 11.06.2003
(73) Patentinhaber: Botest Systems GmbH, 97892 Kreuzwertheim (DE)
(72) Erfinder: STENGEL, Jürgen, 31707 Heessen (DE)
(74) Vertreter: Hengelhaupt, Jürgen
(86) Internationale Anmeldenummer: PCT/EP2001/008882
(87) Internationale Veröffentlichungsnummer: WO 2002/012911

(56) Entgegenhaltungen:
- EP-A- 0 409 398
- US-A- 5 357 194
- US-A- 5 680 056

## Beschreibung

Die vorliegende Erfindung betrifft ein Verfahren zur Prüfung von Leiterplatten auf Funktionsfähigkeit sowie eine Vorrichtung zur Durchführung des Verfahrens.

Zur Prüfung auf Funktionsfähigkeit von Leiterplatten, d. h., eine Prüfung auf Stromdurchfluß innerhalb von Leiterbahnen sowohl auf einer Seite der Leiterplatte wie auch von einer Seite zur anderen ist unter dem Begriff "Bareboard Testsystem" ein Verfahren bekannt, bei dem eine Prüfung auf elektrische Durchgängigkeit der Leiterbahnen durch federnde Kontaktstifte erfolgt, die beidseitig der Leiterplatte in einem Stempel befestigt sind und in ihrer Anordnung entsprechend den Kontaktpunkten konfiguriert sind.

Um eine sichere Anlage der Kontaktstifte an den entsprechenden Kontaktpunkten zu gewährleisten, werden die Stempel mit einem bestimmten Druck gegen die Leiterplatte gefahren, wobei die aus den Federn der Kontaktstifte resultierenden Kräfte überwunden werden müssen. Bei der Vielzahl von Kontaktstiften, die üblicherweise eingesetzt werden, sind erhebliche Drücke erforderlich, die eine entsprechende maschinelle Konzeption bedingen.

Der apparative Aufwand, der hierbei betrieben werden muß, führt zu erheblichen Herstellungskosten einer solchen Maschine, wobei als weiterer Nachteil die relativ große Störanfälligkeit zu beklagen ist, die insbesondere durch die hohe Anzahl von verwendeten Kontaktstiften, die durchaus im Bereich von 10.000 Stück liegen kann, verursacht wird.
Die mit neueren Technologien mögliche zunehmende Dichte der Kontaktpunkte setzt dem Einsatz von Kontaktstiften Grenzen, so daß die erreichbare Auflösung zur Kontaktierung der Leiterplatte modernen Anforderungen nicht mehr Stand hält.

Ein weiteres Verfahren, ist unter dem Begriff "Flying Probetester" bekannt. Dabei werden je 2 bis 8 Prüfnadeln auf beiden Seiten der Leiterplatte durch geeignete Verfahreinheiten über den Kontaktpunkten der Leiterplatte positioniert, für die die elektrische Durchgängigkeit ermittelt werden soll. Eine Kontaktierung zwischen den Prüfnadeln und dem ausgewählten Kontaktpunkt auf der Leiterplatte erfolgt durch Absenken der Prüfnadeln auf diesen Punkt. Der von der ersten Prüfnadel ausgehenden Strom wird zum Leiterplattenkontakt geleitet, und auf dem anderen Ende der Leiterbahn gleichfalls von einer solchen Prüfnadel empfangen und gemessen. Prinzipiell handelt es sich hierbei also um eine berührende Prüfung, wobei nicht entsprechend den beschriebenen Kontaktstiften jeder Kontaktstelle der Leiterbahn eine Prüfnadel zugeordnet ist, sondern diese, rechnergesteuert, jeweils entsprechend verfahren werden. Dabei besteht die Gefahr einer Beschädigung der Kontaktpunkte durch Mehrfachberührung, mit der Folge, daß es zu Problemen bei der Bestückung der Leiterplatte kommen kann.

Um eine solche Beschädigung zu vermeiden, ist schon versucht worden die Prüfnadeln durch ein leitendes Plasma zu ersetzen, wodurch ein Kontakt zu den Kontaktpunkten hergestellt wird.

Nachteilig hierbei ist jedoch, daß die Geschwindigkeit, innerhalb der eine Leiterplatte vollständig geprüft werden kann, relativ niedrig ist. Insbesondere aufgrund der Arbeitsschritte: paarweises Positionieren der Prüfnadeln, Absenken, Messen und Verfahren zu den nächsten Positionen. Auch diese Testsysteme geraten recht bald durch die Größe der Prüfnadeln und nur eingeschränkt mögliche Genauigkeit der Verfahreinheiten an ihre Auflösungs- d.h. Funktionsgrenzen.

Schließlich ist in der US 5 177 437 eine Prüfung von Leiterplatten beschrieben, bei der auf eine Glasplatte eine mittels einer Lichtquelle fotoelektrisch aktivierbare Matrize aufgebracht ist. Zwischen dieser und der Leiterplatte ist eine elektrisch leitfähige Matte vorgesehen. Allerdings ist der konstruktive Aufbau zur Durchführung dieses Verfahrens relativ hoch. Darüber hinaus können durch die zwischengeschaltete Matte und die der Leiterplatte gegenüber starre Matrize herstellungsbedingte Unebenheiten und Ungenauigkeiten der Oberfläche der Leiterplatte nicht ausgeglichen bzw. nicht berücksichtigt werden, so daß ein absolut genaues Prüfergebnis nicht garantiert ist.

Die EP 0 409 398 A2 beschreibt einen Leiterplattentester, bei dem der Prüfling in eine Kammer mit Glasdeckel eingelegt wird. Der Glasdeckel ist von der Innenseite mit einer lichtdurchlässigen Elektrode beschichtet. Der Boden der Kammer ist die Gegenelektrode. Der Prüfling hängt in einer Aufnahme in der Mitte zwischen den Elektroden. Die Kammer wird mit einem inerten Gas befüllt und eine geringe Spannung an die Elektroden angelegt, so dass ein geringes elektrisches Feld entsteht. Über einen fokussierten Laserstrahl wird ein Plasma zwischen der Glasdeckelelektrode und einem ausgewählten Pad des Prüflings gezündet. Dadurch lädt sich der damit verbundene Leiterbahnzug auf.

Im nächsten Schritt wird das elektrische Feld umgepolt und deutlich vergrößert, so dass es zu einem glimmenden Entladungsplasma kommt. Über geeignete Verfahren wird das Glimmen detektiert und mit dem abgespeicherten Muster verglichen.

Weiterhin ist aus der US 5,357,194 eine Vorrichtung zur Prüfung von Leiterplatten bekannt, welche eine photoleitfähige Schicht benutzt und Laserstrahlen einsetzt. Diese photoleitfähige Schicht ist mit kontaktierenden Stangen verbunden.

Zur Funktion sind darüber hinaus als solche bezeichnete "Licht-Ventile" vorgesehen, durch die der ausgesandte Lichtstrahl einer Dauerlichtquelle entsprechend den Erfordernissen ein- und ausgeblendet wird. Der konstruktive Aufwand ist hierbei außerordentlich groß und führt neben hohen Herstellungskosten zu einer einen optimalen Betrieb behindernden Störanfälligkeit.

Der vorliegenden Erfindung liegt daher die Aufgabe zugrunde, ein Verfahren der gattungsgemäßen Art so auszubilden, daß es mit einem geringen apparativen Aufbau und hoher Geschwindigkeit durchführbar ist, eine höhere Prüfgenauigkeit erreicht wird und kleinste Kontaktpunkte der Leiterplatte getestet werden können.

Diese Aufgabe wird durch ein Verfahren gelöst, das die Merkmale des Anspruchs 1 aufweist.

Das erfindungsgemäße Verfahren ermöglicht nun eine hinsichtlich der Arbeitsgeschwindigkeit äußerst effektive und gleichzeitig in bezug auf die Leiterplatte zerstörungsfreie Prüfung.

Durch das unmittelbare Aufbringen einer flexiblen Schicht auf zumindest eine Seite der Leiterplatte, d. h. die direkte Kontaktierung, ist zum einen der konstruktive Aufwand wesentlich geringer als bei den bekannten Verfahren, zum anderen ist gewährleistet, daß auch produktionsbedingte Unebenheiten der Leiterplatte mit berücksichtigt werden. Die zunächst stromundurchlässige Schicht liegt an jedem Punkt der Leiterplatte und aufgrund ihrer flexiblen Beschaffenheit direkt auf, so daß praktisch keine Prüfungenauigkeiten entstehen. Die Qualität des Prüfergebnisses wird somit wesentlich verbessert. Dies ist insbesondere deshalb bemerkenswert, als solche Leiterplatten in großen Stückzahlen Verwendung finden und es von daher auf eine höchstmögliche Qualitätssicherung, zu der eine optimale Prüfung zählt, ankommt.

Der Stromdurchlaß kann durch einen Laserstrahl erzeugt werden, der von einer statischen Quelle ausgeht. Der Strahl wird durch winzige und extrem leichte Spiegel umgelenkt, so daß bei der Positionierung des Strahles in den Bereich des zu überprüfenden Kontaktes der Leiterbahn nur eine geringe Masse bewegt werden muß, was, wie erwähnt, das Verfahren erheblich schneller durchführen läßt als dies im beschriebenen Stand der Technik möglich ist.

Als auf die beiden Seiten der Leiterplatte aufbringbare Schichten können solche aus einem Plasma aufgebracht werden, das einen Raum ausfüllt, der auf einer Seite durch die Leiterplatte begrenzt wird und der im übrigen so weit abgedichtet ist, daß dieses Plasma nicht entströmen kann.

Dabei hat das Plasma den Vorteil, daß es ausschließlich in dem durch den Laserstrahl erzeugten Bereich ionisiert und elektrisch leitfähig wird.

Zur Ermittlung der Durchgängigkeit einer Leiterbahn, die sich auf einer Seite der Leiterplatte befindet, kann eine partionierte Schicht aufgebracht sein, die einen Stromleiter darstellt und die in den Partionen abwechselnd so ausgebildet ist, daß sich in Verbindung mit der unter der Plasma-Schicht liegenden Leiterbahn bei deren einwandfreier Funktionsfähigkeit ein Stromkreis ergibt, der mittels einer angeschlossenen Meßeinrichtung festgestellt werden kann.

Nach einem weiteren Gedanken der Erfindung ist vorgesehen, auf eine Seite der Leiterplatte eine Folie aufzulegen, die eine Äquivalenz zu der genanntenPlasma-Schicht darstellt und auf die vergleichbar dazu ebenfalls eine partionierte Schicht aufgelegt wird. Diese Schicht kann photoleitfähig sein und bspw. aus organischen Halbleitern (speziellen Polymeren) bestehen.

Durch Aufbringen von Folie auf beide Seiten der Leiterplatte ist die Durchgängigkeit von Leiterbahnen prüfbar, die durch die Leiterplatte geführt sind und deren Kontaktstellen auf jeder Seite liegen. Dabei kann auf eine Partionierung der Folien verzichtet werden, da diese gemeinsam einen Stromkreis bilden, in dem die Meßeinrichtung an geeigneter Stelle angeordnet ist. Um bei dieser Anordnung eine einseitig mit Leiterbahnzügen versehene Leiterbahn überprüfen zu können, wird zweckmäßigerweise eine partitionierte Folie verwendet.

Als Folie eignet sich insbesondere eine sogenannte Polymer-Folie, die in dem durch den Laserstrahl bestrahlten Bereich stromleitend wird, allerdings unmittelbar nach Abschalten des Laserstrahls in diesem Bereich wieder stromundurchlässig.

Hierdurch ist die Möglichkeit gegeben, den Laserstrahl in sehr kurzer zeitlicher Folge an den unterschiedlichsten Stellen zu positionieren, so daß problemlos die einzelnen Kontaktstellen der Leiterplatte vom Strom durchflossen werden. In dem Fall, daß diese Kontaktstelle fehlerhaft ist, also kein Strom fließt, wird dies durch die in den Stromkreis integrierte Meßtechnik angezeigt.

Es ist beispielsweise durch Protokollführung jederzeit feststellbar, an welcher Kontaktposition die Leiterplatte fehlerhaft ist.

Weitere vorteilhafte Weiterbildungen der Erfindung sind in den Unteransprüchen gekennzeichnet.

Das erfindungsgemäße Verfahren sowie eine Vorrichtung zu dessen Durchführung wird nachfolgend anhand der beigefügten Zeichnungen beschrieben.

Es zeigen:
- Figur 1: ein Ausführungsbeispiel einer Vorrichtung zur Durchführung des Verfahrens in einer schematischen Seitenansicht,
- Figur 2: ein weiteres Ausführungsbeispiel einer solchen Vorrichtung ebenfalls in einer schematischen Seitenansicht,
- Figur 3: eine schematische Draufsicht auf die Vorrichtung nach der Figur 2.

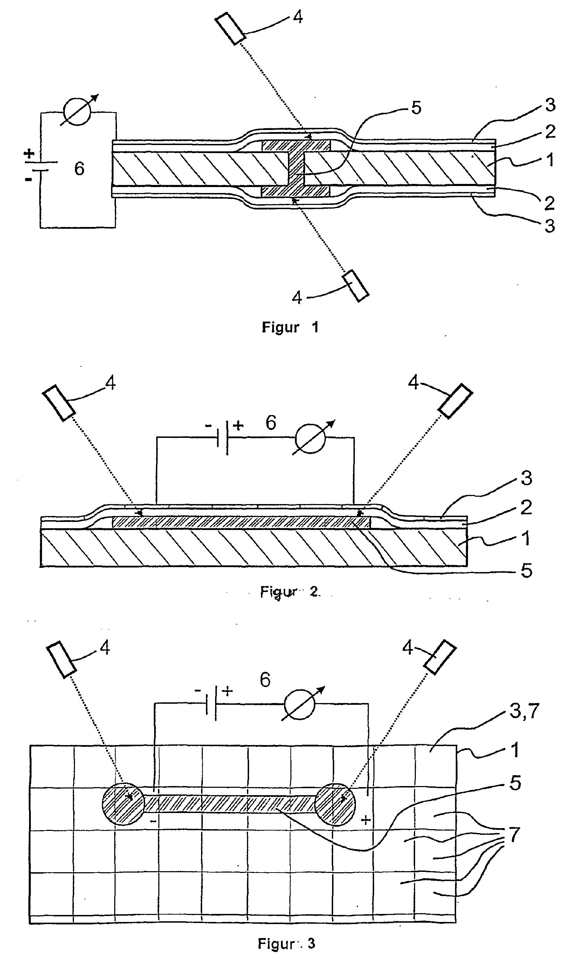

In der Figur 1 ist eine Vorrichtung erkennbar, mit der eine Prüfung von Leiterplatten 1 auf Funktionsfähigkeit durchgeführt werden kann.

Dabei wird der Stromdurchgang durch eine Leiterbahn 5 ermittelt, die quer durch die Leiterplatte 1 geführt ist, so daß beidseitig der Leiterplatte 1 Kontaktstellen vorhanden sind, die die Leiterbahn 5 begrenzen.

Auf den sich gegenüber liegenden Seiten der Leiterplatte 1 ist jeweils eine zunächst stromundurchlässige, flexible Schicht 2 in Form einer Polymer-Folie kontaktierend aufgebracht, von denen jede mit einem der beiden Polen einer Spannungsquelle verbunden ist.
Zwischen den durchsichtigen Schichten 2 und den zu prüfenden Kontaktstellen auf der Leiterplatte 1 wird durch die angelegte Spannung ein elektrisches Feld aufgebaut.

Beidseitig ist ein Sender 4 angeordnet, mit dem ein Laser-Strahl erzeugt und vorzugsweise abgelenkt wird, der die jeweils zugeordnete Schicht 2 in einem Bereich seines Strahldurchmessers durchdringt.

In diesem Bereich ist die Schicht 2 dann stromdurchlässig, so daß in dem Fall, daß die Leiterbahn 5 unbeschädigt ist, der Stromkreis geschlossen ist.

Eine Meß-Quellen-Einrichtung 6 ist zwischen den beiden Schichten, diese verbindend, angeordnet, um zum einen eine Spannungsdifferenz anzulegen und zum andern festzustellen, ob Strom durch die Leiterbahn 5 fließt oder nicht.

In den Figuren 2 und 3 ist eine Vorrichtung gezeigt, mit der eine Leiterbahn 5 auf Durchgängigkeit geprüft wird, die lediglich auf einer Seite der Leiterplatte 1 vorgesehen ist.

Dabei ist auf die Schicht 2 zumindest im Prüfbereich ein Stromleiter 3 in Form einer Schicht, vorzugsweise als flächenartige, lichtdurchlässige Elektrode kontaktierend aufgebracht, die einen ungehinderten Durchgang des Laserstrahles, der gepunktet dargestellt ist, ermöglicht und einstückig mit der photoleitfähigen Schicht 2 ausgebildet sein kann. In diesem Fall bildet der Stromleiter 3, d.h. die Elektrode, eine Trägerschicht für die Schicht 2.

Wie insbesondere die Figur 3 sehr deutlich zeigt, ist der Stromleiter 3 partitioniert in Felder 7 gegliedert, die schachbrettartig angeordnet unterschiedlich gepolt sind, wobei jeder die Leiterbahn 5 begrenzenden Kontaktstelle ein unterschiedlich gepoltes Feld 7 zugeordnet ist.
Hierdurch wird ein Stromleiterkreis aufgebaut, an den die Meß-Quellen-Einrichtung 6 angeschlossen ist, durch die die Durchgängigkeit der Leiterbahn 5 ermittelbar ist.

## Patentansprüche

1. Verfahren zur Prüfung von Leiterplatten auf Funktionsfähigkeit unter Einsatz von photoleitfähigen Schichten und Laserstrahlen, **dadurch gekennzeichnet, dass** unmittelbar auf mindestens eine Seite der Leiterplatte (1) eine zunächst stromundurchlässige, flexible Schicht (2) aus photoleitfähiger Polymer-Folie kontaktierend gebracht wird, die mit einem Stromleiter (3) in Wirkverbindung steht, die Schicht (2) dann unter Spannung gesetzt und danach zu den Kontaktstellen, die eine jeweilige zu überprüfende Leiterbahn (5) begrenzen, ein Stromdurchlass geschaffen wird und anschließend über den Stromleiter (3) der Stromfluss in der Leiterbahn (5) gemessen wird, wobei der Stromdurchlass durch einen Laserstrahl erzeugt wird, der die Schicht (2) im Bereich der Stelle der Leiterbahn (5) durchdringt.

2. Verfahren nach Anspruch 1, **dadurch gekennzeichnet, dass** der Stromleiter (3) vollflächig auf die Schicht (2) aufgebracht wird.

3. Vorrichtung zur Prüfung von Leiterplatten (1) mit Leiterbahnen (5) auf Funktionsfähigkeit unter Einsatz von Sendern (4) zur Erzeugung von Laserstrahlen, wobei die Leiterplatte (1) Kontaktstellen aufweist, die eine jeweilige zu überprüfende Leiterbahn (5) begrenzen, **dadurch gekennzeichnet, dass**
- unmittelbar auf mindestens einer Seite der Leiterplatte (1) eine photoleitfähige, flexible Schicht (2) aus Polymer-Folie kontaktierend angeordnet ist;
- ein Stromleiter (3) in Wirkverbindung mit der Schicht (2) vorgesehen ist;
- eine Messeinrichtung (6) vorgesehen ist, die die Schicht (2) unter Spannung setzt und nach Schaffung eines Stromdurchlasses mittels der Sender (4) zu den Kontaktstellen, die eine jeweilige Leiterbahn (5) begrenzen, über den Stromleiter (3) den Stromfluss in der Leiterbahn (5) misst.

4. Vorrichtung nach Anspruch 3, **dadurch gekennzeichnet, dass** der Stromleiter (3) aus einer lichtdurchlässigen, partitionierten Folie besteht, wobei die Felder (7) schachbrettartig unterschiedlich gepolt sind.

5. Vorrichtung nach Anspruch 3, **dadurch gekennzeichnet, dass** der Stromleiter (3) aus einer Polymer-Folie besteht, die auf der der Schicht (2) gegenüber liegenden Seite kontaktierend auf der Leiterplatte (1) aufliegt.

6. Vorrichtung nach Anspruch 3, **dadurch gekennzeichnet, dass** der Stromleiter (3) als flächenartige, lichtdurchlässige Elektrode ausgebildet ist, die die Schicht (2) zumindest im Prüfbereich überdeckt.

7. Vorrichtung nach Anspruch 3, **dadurch gekennzeichnet, dass** der als Elektrode ausgebildetete Stromleiter (3) und die Schicht (2) einstückig ausgebildet sind.

## Claims

1. Process for testing circuit boards with respect to serviceability using photoconductive layers and laser beams, **characterized by** placing a flexible layer (2), made from photoconductive polymer film and being initially impermeable to current, directly on at least one side of a circuit board (1), thus forming a contact, the flexible layer (2) being dynamically connected to a current conductor (3), and then energizing the layer (2) and thereafter creating a current passage at the contact points that delimit a respective conductor path (5) to be tested, and subsequently measuring a current flow in the conductor path (5) via the current conductor (3), wherein the current passage is produced by a laser beam that penetrates the layer (2) in the area of the location of the conductor path (5).

2. Process according to claim 1, wherein the current conductor (3) is applied to the entire surface of the layer (2).

3. Device for serviceability tests of circuit boards (1) with conductor paths (5), wherein transmitters (4) for generating laser beams are being used, and wherein the circuit board (1) comprises contact points, which delimit a particular conductor path (5) to be tested, **characterized in that**
- a photoconductive, flexible layer (2) is arranged directly on at least one side of the circuit board (1);
- a current conductor (3) being dynamically connected to the layer (2) is provided;
- a measuring device (6) is provided, which energizes the layer (2) and which, after a current passage to contact points delimiting the corresponding conductor path (5) is created by means of the transmitter (4), measures a current in the conductor path (5) via the current conductor (3).

4. Device according to claim 3, wherein the current conductor (3) comprises a transparent, partitioned film having areas (7), which exhibit a different polarity in a checkerboard manner.

5. Device according to claim 3, wherein the current conductor (3) comprises a polymer film, which rests upon the side being opposite to the side of the layer (2) making contact to the circuit board (1).

6. Device according to claim 3, wherein the current conductor (3) is realized as a planar, light transparent electrode which covers the layer (2) in at least the test area.

7. Device according to claim 3, wherein the current conductor (3) realized as an electrode and the layer (2) are realized as a single piece, respectively.

## Revendications

1. Procédé pour tester le fonctionnement de plaquettes de circuits imprimés en utilisant des couches photoconductrices et des faisceaux laser, **caractérisé en ce que** directement sur au moins une face de la plaquette de circuits imprimés (1), une couche flexible (2) ne laissant pas passer le courant dans un premier temps et en feuille polymère photoconductrice est mise en place de manière à établir un contact, laquelle est en liaison active avec un conducteur (3), **en ce que** la couche (2) est ensuite mise sous tension et **en ce qu'**un passage de courant vers les emplacements de contact délimitant une piste conductrice (5) devant être respectivement vérifiée est ensuite créé, et **en ce que** le flux de courant dans la piste conductrice (5) est ensuite mesuré via le conducteur (3), moyennant quoi le passage du courant est généré grâce à un faisceau laser qui pénètre à travers la couche (2) dans la zone de l'emplacement de la piste conductrice (5).

2. Procédé selon la revendication 1, **caractérisé en ce que** le conducteur (3) est appliqué sur toute la surface sur la couche (2).

3. Dispositif pour tester le fonctionnement de plaquettes de circuits imprimés (1) avec des pistes conductrices (5) en utilisant des dispositifs d'émission (4) pour la génération de faisceaux laser, la plaquette de circuits imprimés (1) présentant des emplacements de contact délimitant une piste conductrice (5) devant être respectivement vérifiée, **caractérisé en ce que**
- directement sur au moins une face de la plaquette de circuits imprimés (1), une couche flexible (2) photoconductrice en feuille polymère est mise en place de manière à établir un contact ;
- un conducteur (3) en liaison active avec la couche (2) est prévu ;
- un dispositif de mesurage (6) est prévu, lequel met la couche (2) sous tension et lequel, après avoir créé un passage de courant à l'aide des dispositifs d'émission (4) vers les emplacement de contact qui délimitent une piste conductrice (5) respective, mesure le flux de courant dans la piste conductrice (5) via le conducteur (3).

4. Dispositif selon la revendication 3, **caractérisé en ce que** le conducteur (3) se compose d'une feuille segmentée perméable à la lumière, les champs (7) étant polarisés différemment à la manière d'un damier.

5. Dispositif selon la revendication 3, **caractérisé en ce que** le conducteur (3) se compose d'une feuille polymère, laquelle repose de manière à établir un contact sur la face située en vis à vis de la couche (2) sur la plaquette de circuits imprimés (1).

6. Dispositif selon la revendication 3, **caractérisé en ce que** le conducteur (3) est réalisé en tant qu'électrode transparente en nappe, laquelle recouvre la couche (2) au moins dans la zone de vérification.

7. Dispositif selon la revendication 3, **caractérisé en ce que** le conducteur (3) réalisé en tant qu'électrode et la couche (2), sont réalisés d'une seule pièce.
